# EUROPEAN PATENT SPECIFICATION

(11) **EP 3 842 643 B1**
(45) Date of publication and mention of the grant of the patent: **01.05.2024**
(21) Application number: 20163936.6
(22) Date of filing: 18.03.2020
(51) Int. Cl.: F04D 29/28, F04D 29/30, F04D 29/66

(54) **IMPELLER AND COOLING FAN INCLUDING THE IMPELLER**
LAUFRAD UND KÜHLGEBLÄSE MIT DEM LAUFRAD
ROTOR ET VENTILATEUR DE REFROIDISSEMENT COMPRENANT LE ROTOR

(30) Priority: 24.12.2019 TW 108147421
(43) Date of publication of application: 30.06.2021
(73) Proprietor: Sunonwealth Electric Machine Industry Co., Ltd., Kaohsiung City / Taiwan, R.O.C. (TW)
(72) Inventor: HORNG, Alex, Kaohsiung, Taiwan, R.O.C. (TW); TSENG, Chien-Yuan, Kaohsiung, Taiwan, R.O.C. (TW); WANG, Chi-Min, Kaohsiung, Taiwan, R.O.C. (TW)
(74) Representative: Louis Pöhlau Lohrentz

(56) References cited:
- CN-U- 209 569 198
- GB-A- 2 478 646
- TW-A- 200 903 233
- TW-U- M 516 103
- US-A1- 2015 152 883
- US-A1- 2016 290 355

## Description

### BACKGROUND OF THE INVENTION

### 1. Field of the Invention

The present invention generally relates to an air-driving device and, more particularly, to an impeller and a cooling fan including the impeller.

### 2. Description of the Related Art

As thinness, lightness and high performance are required for the development of the electronic devices, miniaturization of the cooling fan is needed in addition to providing the electronic devices with the cooling function. The size of the cooling fan is usually reduced by reducing the thickness of the blades. However, this lowers the strength of the blades and adversely affects the stability of rotation. In light of this, another type of the cooling fan was proposed which includes a ring connected to one side of the blades. As such, the interconnection of the blades through the ring can improve the stability of the blades of the impeller. An example of such a cooling fan is seen in Taiwan Patent No. M516103.

However, although the blades are interconnected through the ring, the rotation of the impeller is still not sufficiently stable due to the reduced thickness and strength of the blades. In this regard, the blades tend to vibrate or even deform under the air resistance, which leads to larger vibration and noise and significantly affects the stability in operation of the fan.

TW 200903233 A discloses a fan impeller including a hub and a plurality of blades arranged around the hub. At least one filament extends through a free end of each of the blades. The filament has an annular configuration which is homocentric with the fan impeller.

US 2016/290355 A1 discloses a fan impeller including a plurality of fan blade assembly members, each one of the fan blade assembly members respectively includes a metal ring bracket and a plurality of metal blades, one end of each one of the metal blades is respectively connected to the corresponding metal ring bracket and the plurality of metal blades of each one of the fan blade assembly members arranged radially to circumference the corresponding metal ring bracket.

In light of this, it is necessary to improve the conventional cooling fan.

### SUMMARY OF THE INVENTION

It is therefore the objective of this invention to provide an impeller and a cooling fan including the impeller, in which the vibration of the impeller can be reduced during the rotation to thereby improve the stability of rotation and to reduce the noise.

It is another objective of this invention to provide an impeller and a cooling fan including the impeller which are capable of driving a larger volume of air.

It is a further objective of this invention to provide an impeller and a cooling fan including the impeller which have improved operational efficiency.

It is yet a further objective of this invention to provide an impeller and a cooling fan including the impeller which have a lower manufacturing cost.

As used herein, the term "one" or "an" for describing the number of the elements and members of the present invention is used for convenience, provides the general meaning of the scope of the present invention, and should be interpreted to include one or at least one. Furthermore, unless explicitly indicated otherwise, the concept of a single component also includes the case of plural components.

As used herein, the term "coupling", "join", "assembly" or the like is used to include separation of connected members without destroying the members after connection or inseparable connection of the members after connection. A person having ordinary skill in the art would be able to select the type of connection according to desired demands in the material or assembly of the members to be connected.

In an aspect, an impeller includes a hub, a plurality of blades provided around an outer periphery of the hub, and at least two connecting rings connected to the plurality of blades. Each of the plurality of blades has a top edge and a bottom edge opposite to the top edge. One or more of the at least two connecting rings is disposed between but not connected to the top edges and the bottom edges of the plurality of blades.

In another aspect, a cooling fan includes a fan frame, a stator and the impeller. The fan frame includes a base having a shaft tube. The stator is mounted around an outer periphery of the shaft tube. The impeller is rotatably coupled with the shaft tube.

Based on the above, in the impeller and the cooling fan including the impeller according to the invention, the at least two connecting rings can have a sufficient strength by having one or more of the at least two connecting rings disposed between but not connected to the top edges and the bottom edges of the plurality of blades. As such, the plurality of blades can be retained in place to reduce the vibration or deformation of the impeller caused by the plurality of blades suffering from the impact of the air resistance. Advantageously, the rotational stability of the plurality of blades and the performance of the cooling fan can be improved and the noise can be reduced.

In an example, the at least two connecting rings are at a same level. As such, the plurality of blades can be retained in place to improve the stability of the plurality of blades.

In the example, the at least two connecting rings are disposed in a middle between the top edges and the bottom edges of the plurality of blades. As such, the plurality of blades can be better secured, reducing the vibration of the plurality of blades under high-speed rotation.

According to the invention, the hub has an annular wall connected to a first end of each of the plurality of blades, and one of the at least two connecting rings is connected to a second end of each of the plurality of blades. As such, the structure is simple and allows for convenient manufacturing, thereby reducing the manufacturing cost of the impeller.

In the example, the annular wall includes an extension portion extending outwards radially and connecting to the first ends of the plurality of blades. As such, the extension portion can increase the contact area between the plurality of blades and the annular wall of the hub, improving the reliability in engagement between the hub and the plurality of blades.

According to the invention, each of the plurality of blades has a length between a first end and a second end thereof, and each of the at least two connecting rings is connected to each of the plurality of blades at any position from the second end to where it is at one-third of the length from the annular wall. As such, the plurality of blades can be better reinforced to further improve the stability of the plurality of blades.

In the example, each of the plurality of blades has a first end and a second end higher than the first end, and the first end is more adjacent to the hub than the second end is. As such, the plurality of blades is able to drive the air of larger volume.

In the example, a distance between the top edge and the bottom edge of the blade gradually increases from the first end to the second end of the blade. As such, the plurality of blades is able to drive the air of larger volume.

In the example, the at least two connecting rings include two connecting rings. One of the two connecting rings is disposed between but not connected to the top edges and the bottom edges of the plurality of blades. Another of the two connecting rings is connected to the plurality of blades slightly above or below the top edges of the plurality of blades, or slightly above or below the bottom edges of the plurality of blades. As such, the structure is simple and allows for convenient manufacturing, thereby reducing the manufacturing cost of the impeller.

In the example, the hub includes an annular wall connected to an edge of a plate. The plate has a central hole. The hub includes a reinforcing portion around the central hole of the plate. As such, the structure strength of the impeller is improved.

In the example, the reinforcing portion includes a plurality of protruding ribs extending from the central hole towards the annular wall of the hub. As such, the overall structure strength of the hub is improved.

In the example, the reinforcing portion includes an annular rib around the central hole of the hub. As such, the annular rib of the reinforcing portion can increase the structural strength of the plate around the central hole, thereby improving the structural strength of the hub.

In the example, the reinforcing portion further includes a plurality of protruding ribs extending from the annular rib towards the annular wall of the hub. As such, the overall structural strength of the hub is more effectively improved.

In the example, the at least two connecting rings include three connecting rings. One of the three connecting rings is disposed between but not connected to the top edges and the bottom edges of the plurality of blades, and another two of the three connecting rings are connected to the top edges and the bottom edges of the plurality of blades, respectively. This not only provides an alternative arrangement of the impeller but also further secures the plurality of blades in place through the use of the three connecting rings, thereby reducing the vibration or deformation of the impeller caused by the plurality of blades suffering from the impact of the air resistance.

In the example, the one of the three connecting rings is more adjacent to the hub than the other two of the three connecting rings are. As such, the structure is simple and allows for convenient manufacturing, thereby reducing the manufacturing cost of the impeller.

In the example, each of the plurality of blades has a thickness of 0.02 to 0.5 mm. As such, the cooling fan as a whole can remain in a slim fashion, preventing overweighting of the impeller and thereby improving the performance of the cooling fan.

In another example, each of the plurality of blades has a thickness smaller than 0.1 mm. As such, the cooling fan as a whole can remain in a slim fashion, preventing overweighting of the impeller and thereby improving the performance of the cooling fan.

In the example, a quantity of the plurality of blades is 70 to 134. As such, the plurality of blades that has a reduced thickness will be able to drive air of sufficient volume, thereby improving the air-driving effect of the impeller.

In another example, a quantity of the plurality of blades is 91 to 134. As such, the plurality of blades that has a reduced thickness will be able to drive air of sufficient volume, thereby improving the air-driving effect of the impeller.

In the example, an outer diameter of the impeller is larger than or equal to 40 mm. As such, the plurality of blades that has a reduced thickness will be able to drive air of sufficient volume, thereby improving the air-driving effect of the impeller.

In the example, the plurality of blades and the at least two connecting rings are made of polymer. As such, the structural strength of the plurality of blades and the two connecting rings is improved.

In the example, the polymer is a mixture of liquid crystal polymer and carbon fiber. As such, the material will have a better tensile strength and a heat resistance to allow for convenient manufacturing and to attain a higher structural strength.

In the example, the polymer is a mixture of liquid crystal polymer and mineral fiber. As such, the material will have a better tensile strength and a heat resistance to allow for convenient manufacturing and to attain a higher structural strength.

In the example, the polymer is a mixture of liquid crystal polymer, glass fiber and mineral fiber. As such, the material will have a better tensile strength and a heat resistance to allow for convenient manufacturing and to attain a higher structural strength.

In the example, the plurality of blades does not extend beyond a top face of the hub. As such, the axial height of the impeller can be reduced.

According to the invention, each of the at least two connecting rings has a thickness larger than or equal to a maximum thickness of each of the plurality of blades. As such, it can be ensured that the connecting rings have a sufficient strength to reinforce the plurality of blades, thus improving the stability of the plurality of blades.

According to the invention, each of the at least two connecting rings has a radial width larger than or equal to a maximum thickness of each of the plurality of blades. As such, it can be ensured that the connecting rings have a sufficient strength to reinforce the plurality of blades, thus improving the stability of the plurality of blades.

### BRIEF DESCRIPTION OF THE DRAWINGS

The present invention will become more fully understood from the detailed description given hereinafter and the accompanying drawings which are given by way of illustration only, and thus are not limitative of the present invention, and wherein:
FIG. 1 is a perspective view of an impeller according to a first embodiment of the invention.
FIG. 2 is a top view of the impeller of FIG. 1.
FIG. 3 is a cross sectional view of the impeller taken along line 3-3 of FIG. 2.
FIG. 4 is a cross sectional view of a cooling fan including the impeller of the first embodiment of the invention.
FIG. 5a is a partial, cross sectional view of an impeller according to a second example, which is not part of the present invention.
FIG. 5b is a partial, cross sectional view of an impeller according to another implementation of the second example.
FIG. 6 is a partial, cross sectional view of an impeller according to a third example, which is not part of the present invention.
FIG. 7 is a partial, cross sectional view of an impeller according to a fourth example, which is not part of the present invention.
FIG. 8 shows three sets of air volume test results of a cooling fan under 1 atm for different arrangements of two connecting rings of the impeller of the invention and the comparative examples.

In the various figures of the drawings, the same numerals designate the same or similar parts. Furthermore, when the terms "first", "second", "third", "fourth", "inner", "outer", "top", "bottom", "front", "rear" and similar terms are used hereinafter, it should be understood that these terms have reference only to the structure shown in the drawings as it would appear to a person viewing the drawings, and are utilized only to facilitate describing the invention.

### DETAILED DESCRIPTION OF THE INVENTION

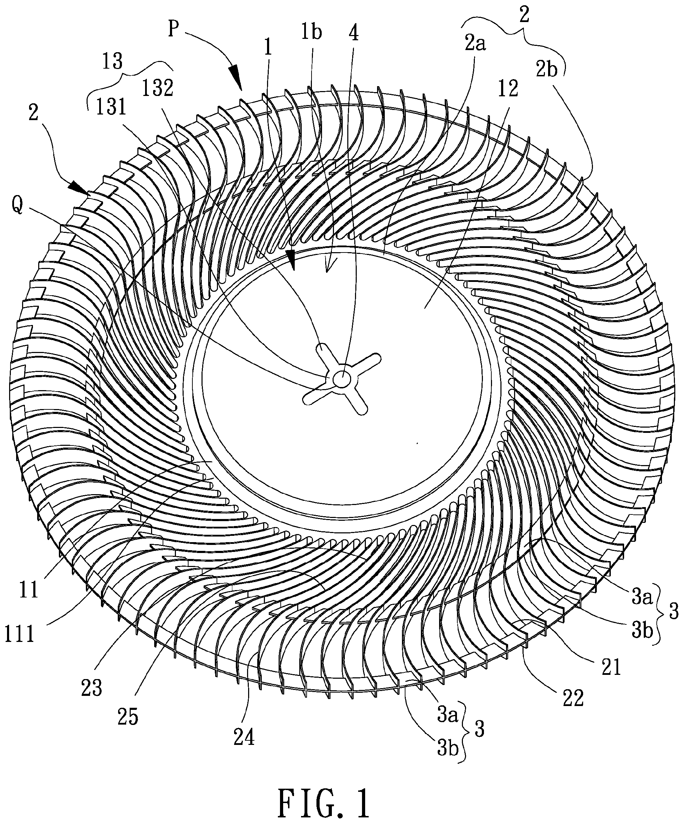

FIG. 1 shows an impeller **P** according to a first embodiment of the invention. The impeller **P** includes a hub 1, a plurality of blades 2 coupled with the outer periphery of the hub 1, and at least two connecting rings 3 connected to the plurality of blades 2. The impeller **P** according to the invention can be used to form a centrifugal fan or a crossflow fan. The following description is made with the centrifugal fan, but it is not intended to limit the invention.

A shaft 4 can be arranged at the center of the hub 1, which can be readily appreciated by one of ordinary skill and therefore it is not described herein for brevity. The hub 1 includes an annular wall 11 connected to the edge of a plate 12. The plate 12 has a central hole **Q.** The annular wall 11 can be coupled with the plurality of blades 2. In this embodiment, the annular wall 11 includes an extension portion 111 that may be integrally formed with the annular wall 11. The extension portion 111 may be located between the at least two connecting rings 3 and the annular wall 11. The extension portion 111 is not connected to the at least two connecting rings 3 but extends radially outward from the annular wall 11 (away from the shaft 4) to connect with the plurality of blades 2. For example, the extension portion 111 is made of plastic material and forms along the outer periphery of the annular wall 11. Thus, when the reduction in thickness of the plurality of blades 2 is required, the extension portion 111 can increase the contact area between the plurality of blades 2 and the annular wall 11 of the hub 1. Advantageously, the plurality of blades 2 can be more securely coupled with the hub 1 without breaking easily.

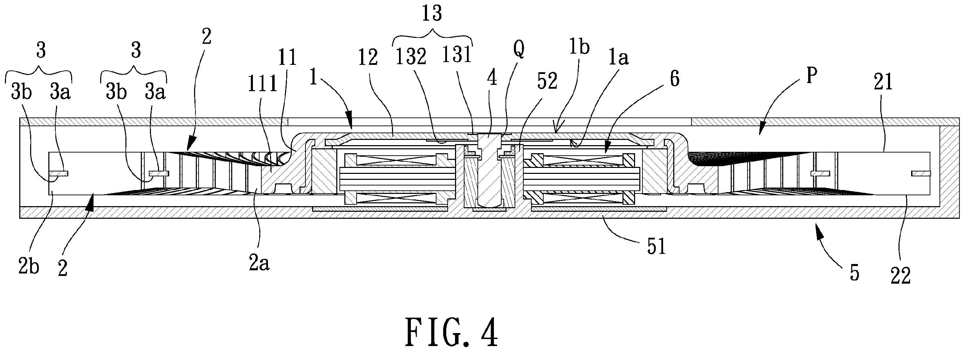

Besides, the hub 1 has an inner face 1a (shown in FIG. 4) and an outer face 1b opposite to the inner face 1a. The hub 1 includes a reinforcing portion 13 around the central hole **Q.** The reinforcing portion 13 is configured to improve the structural strength of the hub 1. In this embodiment, the reinforcing portion 13 provided on the inner face 1a of the hub 1 for illustration purpose. Specifically, the reinforcing portion 13 includes an annular rib 131 around the central hole **Q.** The annular rib 131 can increase the structural strength of the plate 12 around the central hole **Q.** The reinforcing portion 13 can further include a plurality of protruding ribs 132 connecting to the annular rib 131 and extending towards the annular wall 11. As a preferred case of this arrangement, the plurality of protruding ribs 132 extends radially from the central hole **Q,** further improving the structural strength of the hub 1.

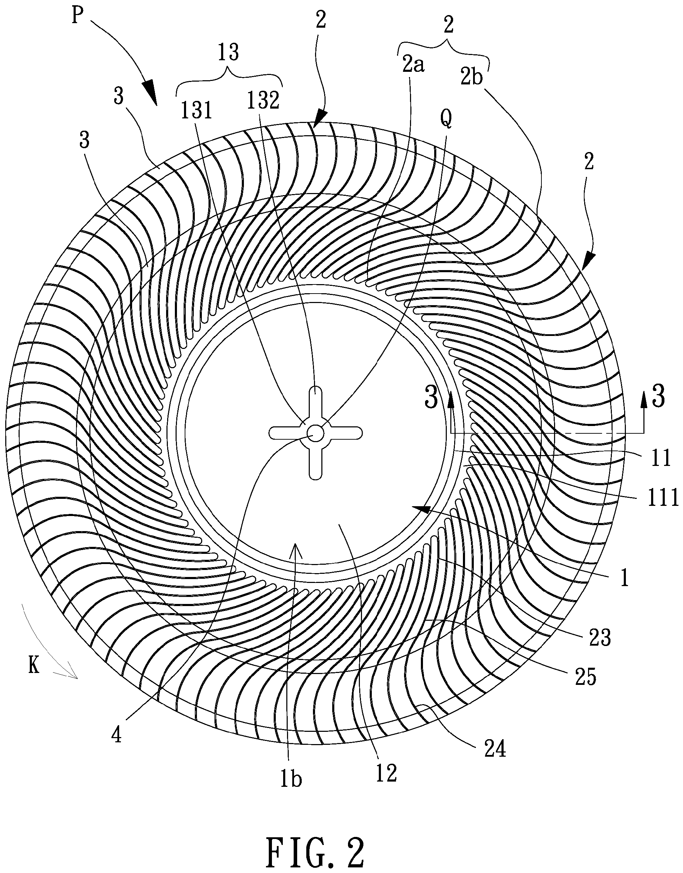

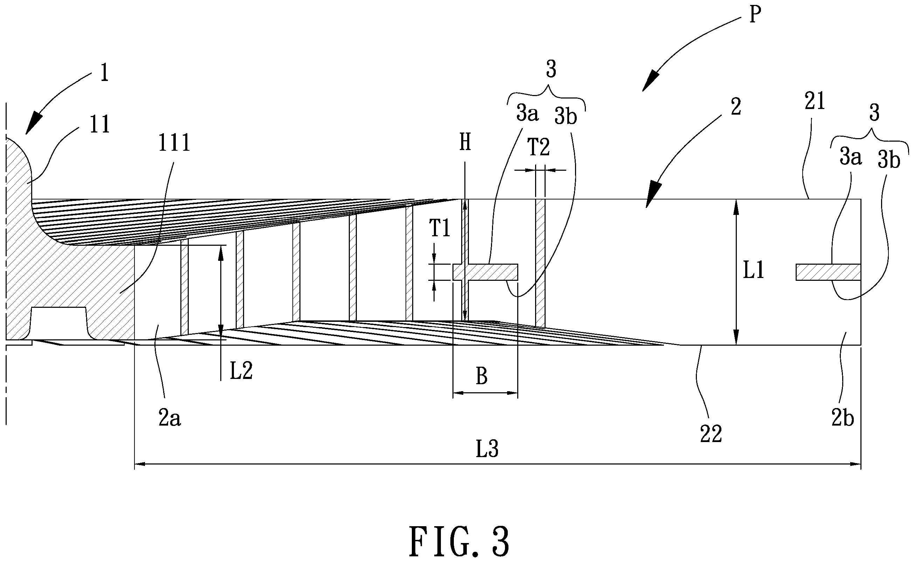

Referring to FIGS. 2 and 3, the plurality of blades 2 preferably does not extend beyond the top face of the hub 1 to reduce the thickness of the impeller **P.** Each of the plurality of blades 2 includes a first end 2a connected to the extension portion 111 of the annular wall 11, as well as a second end 2b opposite to the first end 2a and having a height L1 larger than a height L2 of the first end 2a. The material of the plurality of blades 2 is not limited. Each of the plurality of blades 2 can be connected to the annular wall 11 by ways of fastening, adhesion or integral formation, which is not taken in a limited sense in the invention. For example, when the annular wall 11 and the plurality of blades 2 are made of the same material, integral formation can be used to improve the structural strength and production efficiency. In this embodiment, the annular wall 11, the plurality of blades 2 and the at least two connecting rings 3 are made of polymer and are connected to the hub 1 by injection molding. The polymer is preferably the mixture of liquid crystal polymer and carbon fiber, the mixture of liquid crystal polymer and mineral fiber, or the mixture of liquid crystal polymer, glass fiber and mineral fiber. Alternatively, the metal powder of iron, aluminum, copper or alloy can be mixed with polymer adhesive to form the impeller **P** through injection molding of the mixture. This approach also improves the structural strength of the impeller **P.**

Referring to FIGS. 1 and 3, each of the plurality of blades 2 has a top edge 21 and a bottom edge 22 opposite to the top edge 21. The distance between the top edge 21 and the bottom edge 22 gradually increases from the first end 2a to the second end 2b as shown in FIG. 3, enabling the plurality of blades 2 to drive a larger volume of air. The height L2 of the second end 2b of the blade 2 may be 1-6 mm, and is preferably 1.7-4.7 mm. The thickness of the blade 2 may be 0.02-0.5 mm, with 0.1 mm preferred. This remains the fan in a slim fashion and prevents the overweighting of the impeller **P,** advantageously improving the operational efficiency thereof. The quantity of the plurality of blades 2 can be 70-134, and is preferably 91-134. The outer diameter of the impeller **P** can be larger than or equal to 40 mm, such that the slim blades 2 can drive air of sufficient volume and can be disposed around the hub 1.

Referring to FIG. 3, the connecting ring 3 has a thickness T1 which is larger than or equal to the maximum thickness T2 of the blade 2 and is smaller than a quarter of the maximum height **H** of the blade 2 connecting to the connecting ring 3. Furthermore, the radial width **B** of the connecting ring 3 is larger than or equal to the maximum thickness T2 of the blade 2, and is smaller than or equal to one sixth of the length L3 of the blade 2. In this arrangement, it can be ensured that the connecting ring 3 has a sufficient strength to reinforce the plurality of blades 2, thereby improving the stability of the plurality of blades 2.

Referring to FIGS. 1 and 2, it is particularly noted that the first end 2a and the second end 2b of the blade 2 can align with each other in the same radial direction. In other words, the line passing through the first end 2a and the second end 2b of the blade 2 can pass through the center of the hub 1, such that the plurality of blades 2 can be connected to the hub 1 in a radial fashion. Alternatively, the line passing through the first end 2a and the second end 2b of the blade 2 does not pass through the center of the hub 1, such that each of the plurality of blades 2 is tangential to the annular wall 11 of the hub 1. The invention is limited to either implementation. In this embodiment, each of the plurality of blades 2 includes a rear curving section 23 relatively adjacent to the hub 1, as well as a front curving section 24 relatively distant to the hub 1. The front curving section 24 curves in the same direction as the rotating direction **K** of the impeller **P,** whereas the rear curving section 23 curves in the opposite direction to the rotating direction **K** of the impeller **P.** Both the rear curving section 23 and the front curving section 24 can be in an arched form as shown in the drawing. Each of the plurality of blades 2 may further include an intermediate section 25 connected between the rear curving section 23 and the front curving section 24.

Referring to FIGS. 2 and 3, the at least two connecting rings 3 are connected to any portions of the blade 2 between the first end 2a and the second end 2b, but are not connected to the extension portion 111. For example, one of the at least two connecting rings 3 is connected to the middle of the blade 2 half of the length L3 from either end of the blade 2, or is connected to the rear curving section 23 or the front curving section 24. According to the invention, each of the at least two connecting rings 3 is connected to the blade 2 at any position from the second end 2b to where it is at one-third of the length L3 from the annular wall 11. Alternatively, one of the at least two connecting rings 3 is connected to the blade 2 at any position from the second end 2b to where it is at one-third of the length L3 from the annular wall 11, and the other connecting ring 3 is directly connected to the intermediate section 25 to better reinforce the plurality of blades 2. As such, the stability of the plurality of blades 2 is improved, and therefore the vibration of the plurality of blades 2 under high-speed rotation is reduced.

Specifically, each of the at least two connecting rings 3 includes a first face 3a and a second face 3b opposite to the first face 3a. The first face 3a faces the top edge 21 of the blade 2 and the second face 3b faces the bottom edge 22 of the blade 2. At least one of the at least two connecting rings 3 is connected between the top edges 21 and the bottom edges 22 of the blade 2. In this regard, the first face 3a of said at least one connecting ring 3 is not connected to the top edges 21 of the blades 2, and the second face 3b of said at least one connecting ring 3 is not connected to the bottom edges 22 of the blades 2.

Specifically, as an example of the at least two connecting rings 3 including two connecting rings 3, one of the two connecting rings 3 is disposed between but not connected to the top edges 21 and the bottom edges 22 of the blades 2. In this embodiment, both the two connecting rings 3 are disposed between but not connected to the top edges 21 and the bottom edges 22 of the blades 2 to enhance the stability of the blades 2. Preferably, the two connecting rings 3 are in the same level as shown in FIG. 3.

Besides, in this embodiment, the first face 3a of each connecting ring 3 is equally spaced from the top edge 21 as the second face 3b is spaced from the bottom edge 22, such that each connecting ring 3 is disposed in the middle of the blade 2 having an equal distance from the top edge 21 and the bottom edge 22 of the blade 2. In such an arrangement, a better reinforcement effect can be provided to improve the stability of the plurality of blades 2, further securing the plurality of blades 2 and reducing the vibration of the plurality of blades 2 under high-speed rotation.

Referring to FIGS. 3 and 4, based on the above structure, a cooling fan having the impeller **P** according to the embodiment of the invention includes a fan frame 5. The fan frame 5 includes a base 51 having a shaft tube 52 into which the shaft 4, that is connected to the impeller **P,** is inserted. A stator 6 is fit around the outer periphery of the shaft tube 52. Since the two connecting rings 3 are connected between the top edges 21 and the bottom edges 22 of the plurality of blades 2 without having their first faces 3a connected to the top edges 21 and having their second faces 3b connected to the bottom edges 22, the two connecting rings 3 will have a sufficient strength to secure the plurality of blades 2 in place. This reduces the vibration or deformation of the impeller **P** caused by the blades 2 suffering from the impact of the air resistance, thus improving the overall stability of the blades 2 including its rotational stability and advantageously reducing the noise.

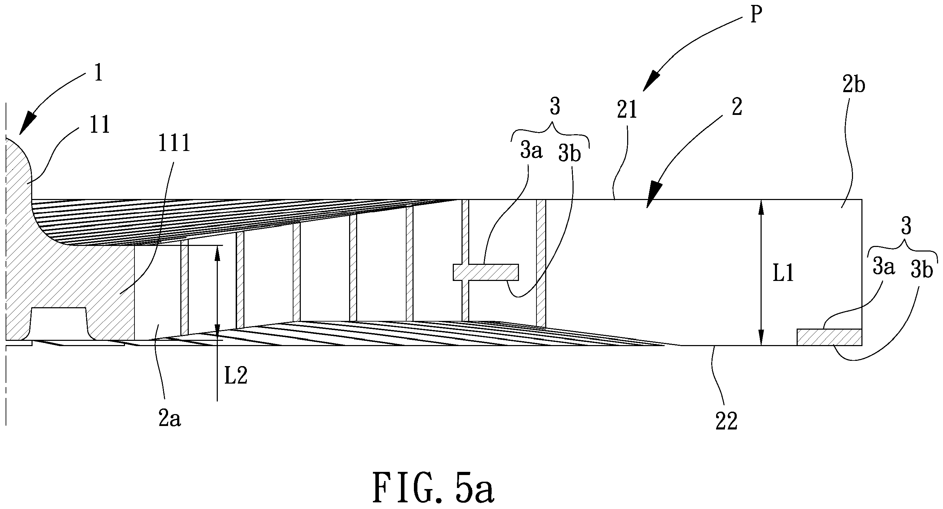

Referring to FIG. 5a showing an impeller **P** according to a second example, which is not part of the invention. One of the two connecting rings 3 is disposed between but not connected to the top edges 21 and the bottom edges 22 of the plurality of blades 2 and is relatively adjacent to the hub 1, whereas the other connecting ring 3 is relatively distant to the hub 1 and is disposed at the second ends 2b of the plurality of blades 2 and is connected to the bottom edges 22 of the plurality of blades 2. The other connecting ring 3 can be connected to the plurality of blades 2 slightly above or below the bottom edges 22 of the plurality of blades 2 as shown in FIG. 5a. For example, the other connecting ring 3 can be flush with the bottom edges 22 of the plurality of blades 2 without protruding beyond said bottom edges 22 , or can partially or completely protrude beyond the bottom edges 22 of the plurality of blades 2. In this example, the other connecting ring 3 is flush with the bottom edges 22 of the plurality of blades 2 without protruding beyond said bottom edges 22; namely, the second face 3b of the other connecting ring 3 is connected to the bottom edges 22 of the plurality of blades 2 as an alternative arrangement of the impeller **P.**

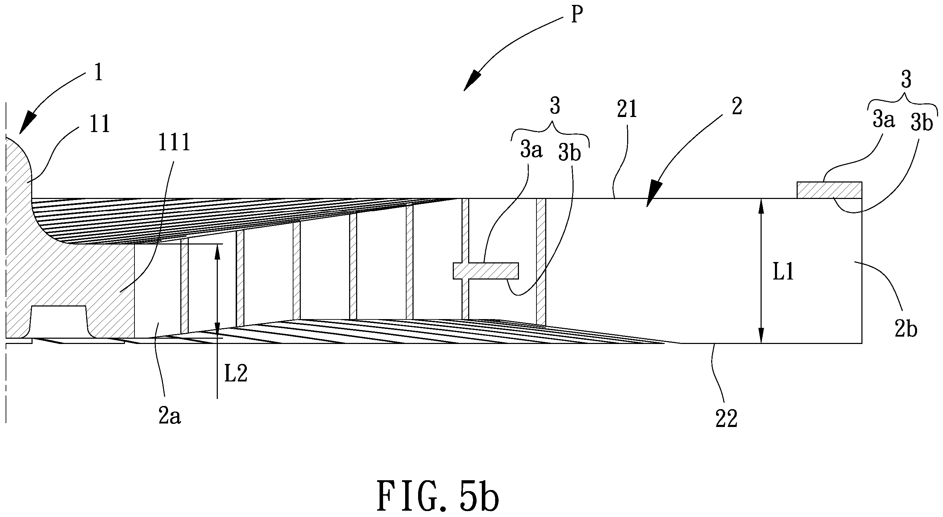

Besides, the other connecting ring 3 can also be connected to the plurality of blades 2 slightly above or below the top edges 21 of the plurality of blades 2. For example, the other connecting ring 3 can be flush with the top edges 21 of the plurality of blades 2 without protruding beyond said top edges 21, or can partially or completely protrude beyond the top edges 21 of the plurality of blades 2. In this example, the other connecting ring 3 can extend completely beyond the top edges 21 of the plurality of blades 2 as shown in FIG. 5b; namely, the second face 3b of the other connecting ring 3 is connected to the top edges 21 of the plurality of blades 2 in a manner that the second face 3b of the other connecting ring 3 is flush with the top edges 21 of the plurality of blades 2. This provides another alternative arrangement of the impeller **P.**

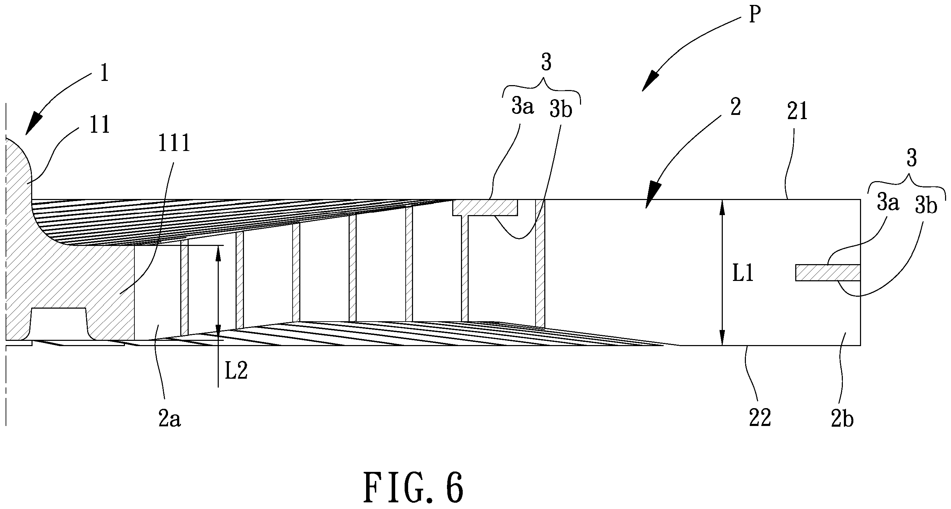

Referring to FIG. 6 showing an impeller **P** according to a third example, which is not part of the present invention. One of the two connecting rings 3 is disposed between but not connected to the top edges 21 and the bottom edges 22 of the plurality of blades 2 and is relatively distant to the hub 1 and is disposed at the second ends 2b of the plurality of blades 2, whereas the other connecting ring 3 is relatively adjacent to the hub 1 and is connected to the plurality of blades 2 slightly above or below the top edges 21 of the plurality of blades 2. For example, the other connecting ring 3 can be flush with the top edges 21 of the plurality of blades 2 without protruding beyond said top edges 21, or can partially or completely protrude beyond the top edges 21 of the plurality of blades 2. In this embodiment, the other connecting ring 3 is flush with the top edges 21 of the plurality of blades 2 without protruding beyond said top edges 21; namely, the first face 3a of the other connecting ring 3 is connected to the top edges 21 of the plurality of blades 2, ensuring that the other connecting ring 3 has larger contact areas with the plurality of blades 2. This reduces the vibration of the blades 2 resulting from the air resistance, thus providing a further alternative arrangement of the impeller **P.**

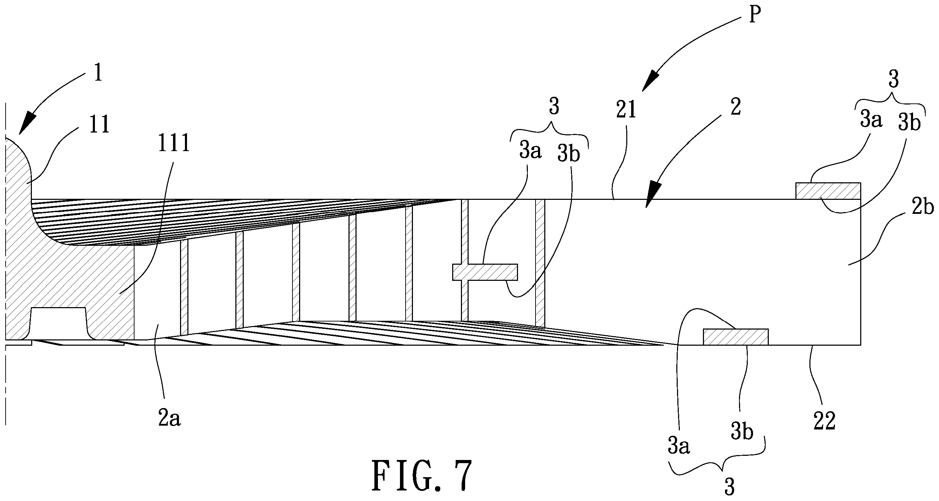

Referring to FIG. 7 showing an impeller **P** according to a fourth example, which is not part of the present invention, where the quantity of the at least two connecting rings 3 is three. One of the three connecting rings 3 is disposed between but not connected to the top edges 21 and the bottom edges 22 of the plurality of blades 2 and is relatively adjacent to the hub 1, whereas the other two connecting rings 3 are relatively distant to the hub 1 and are preferably staggered and are respectively connected to top edges 21 and the bottom edges 22 of the plurality of blades 2. Among the other two connecting rings 3, one connecting ring 3 can be connected to the plurality of blades 2 slightly above or below the top edges 21 of the plurality of blades 2, and the other connecting ring 3 can be connected to the plurality of blades 2 slightly above or below the bottom edges 22 of the plurality of blades 2 as shown in FIG. 7. For example, one connecting ring 3 can be flush with the top edges 21 of the plurality of blades 2 without protruding beyond said top edges 21, or can partially or completely protrude beyond the top edges 21 of the plurality of blades 2. In this regard, the other connecting ring 3 can be flush with the bottom edges 22 of the plurality of blades 2 without protruding beyond said bottom edges 22, or can partially or completely protrude beyond the bottom edges 22 of the plurality of blades 2. In this example, one connecting ring 3 among the other two connecting rings 3 completely protrudes beyond the top edges 21 of the plurality of blades 2, and the other connecting ring 3 is flush with the bottom edges 22 of the plurality of blades 2 without protruding beyond said bottom edges 22 to thereby reduce the height of the impeller. This provides yet a further alternative arrangement of the impeller **P** where the three connecting rings 3 can even better secure the plurality of blades 2 in place, thereby reducing the vibration or deformation of the impeller **P** caused by the plurality of blades 2 suffering from the impact of the air resistance.

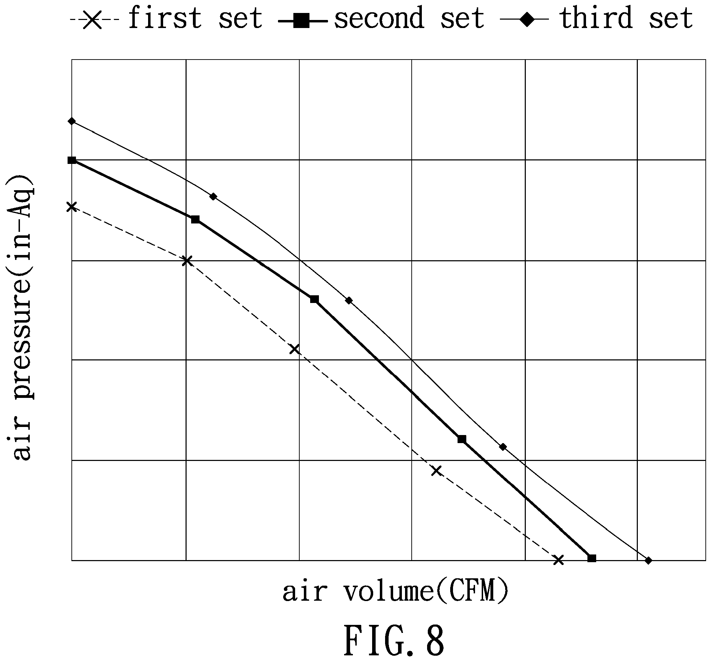

FIG. 8 shows three sets of air volume test results of the cooling fan under 1 atm for different arrangements of the two connecting rings 3 of the impeller **P** according to the invention and some comparative examples. The first set of test result is obtained by having both the connecting rings 3 disposed at the top edges 21 of the plurality of blades 2 (a conventional arrangement not described in the background art). The second set of test result is obtained by having one of the two connecting rings 3, which is relatively adjacent to the hub 1, disposed between the top edges 21 and the bottom edges 22 of the plurality of blades 2, as well as having the other connecting ring 3, which is relatively distant to the hub 1, disposed at the top edges 21 of the plurality of blades 2, as is described in the second example, which is not part of the present invention. The third set of test result is obtained by having both the connecting rings 3 disposed between the top edges 21 and the bottom edges 22 of the plurality of blades 2, as is described in the first embodiment of the invention. These test results show the relationship between the air volume and the air pressure generated during the rotation of the impeller **P** under the same noise level, as shown in FIG. 8.

It can be seen from FIG. 8 that among the three sets of test results, the arrangements of the impeller **P** corresponding to the second and third sets of test results can generate larger air volumes and air pressures as compared with the arrangement of the first set of test result. Therefore, it is proven that the impeller **P** according to the invention can reinforce the plurality of blades 2 and increase the air volume and air pressure.

In summary, in the impeller and the cooling fan including the impeller according to the invention, the at least two connecting rings can have a sufficient strength by having one or more of the at least two connecting rings disposed between but not connected to the top edges and the bottom edges of the plurality of blades. As such, the plurality of blades can be retained in place to reduce the vibration or deformation of the impeller caused by the plurality of blades suffering from the impact of the air resistance. Advantageously, the rotational stability of the plurality of blades and the performance of the cooling fan can be improved and the noise can be reduced.

Although the invention has been described in detail with reference to its presently preferable embodiments, it will be understood by one of ordinary skill in the art that various modifications can be made without departing from the scope of the invention, as set forth in the appended claims.

## Claims

1. An impeller comprising:
a hub (1);
a plurality of blades (2) provided around an outer periphery of the hub (1), wherein each of the plurality of blades (2) has a top edge (21) and a bottom edge (22) opposite to the top edge (21), wherein the impeller further comprises at least two connecting rings (3) connected to the plurality of blades (2), wherein one or more of the at least two connecting rings (3) is disposed between but not connected to the top edges (21) and the bottom edges (22) of the plurality of blades (2);
wherein the impeller is **characterized in that**:
each of the at least two connecting rings (3) has a thickness (T1) larger than or equal to a maximum thickness (T2) of each of the plurality of blades (2);
each of the at least two connecting rings (3) has a radial width (B) larger than or equal to the maximum thickness (T2) of each of the plurality of blades (2),
wherein each of the plurality of blades (2) has a length (L3) between a first end (2a) and a second end (2b) thereof, the hub (1) has an annular wall (11) connected to the first end (2a) of each of the plurality of blades (2), and wherein each of the at least two connecting rings (3) is connected to each of the plurality of blades (2) at any position from the second end (2b) to where it is at one-third of the length (L3) from the annular wall (11).

2. The impeller as claimed in claim 1, **characterized in that** the at least two connecting rings (3) are at a same level.

3. The impeller as claimed in claim 2, **characterized in that** the at least two connecting rings (3) are disposed in a middle between the top edges (21) and the bottom edges (22) of the plurality of blades (2).

4. The impeller as claimed in claim 1, **characterized in that** one of the at least two connecting rings (3) is connected to the second end (2b) of each of the plurality of blades (2).

5. The impeller as claimed in claim 4, **characterized in that** the annular wall (11) includes an extension portion (111) extending outwards radially and connecting to the first ends (2a) of the plurality of blades (2).

6. The impeller as claimed in claim 1, **characterized in that** each of the plurality of blades (2) has the second end (2b) higher than the first end (2a), and wherein a distance between the top edge (21) and the bottom edge (22) of the blade (2) gradually increases from the first end (2a) to the second end (2b) of the blade (2).

7. The impeller as claimed in claim 1, **characterized in that** the at least two connecting rings (3) include two connecting rings (3), wherein one of the two connecting rings (3) is disposed between but not connected to the top edges (21) and the bottom edges (22) of the plurality of blades (2), and wherein another of the two connecting rings (3) is connected to the plurality of blades (2) slightly above or below the top edges (21) of the plurality of blades (2) or slightly above or below the bottom edges (22) of the plurality of blades (2).

8. The impeller as claimed in claim 1, **characterized in that** the at least two connecting rings (3) include three connecting rings (3), wherein one of the three connecting rings (3) is disposed between but not connected to the top edges (21) and the bottom edges (22) of the plurality of blades (2), wherein another two of the three connecting rings (3) are connected to the top edges (21) and the bottom edges (22) of the plurality of blades (2), respectively, and wherein the one of the three connecting rings (3) is more adjacent to the hub (1) than the other two of the three connecting rings (3) are.

9. The impeller as claimed in claim 1, **characterized in that** the plurality of blades (2) and the at least two connecting rings (3) are made of polymer, and wherein the polymer is a mixture of liquid crystal polymer and carbon fiber, a mixture of liquid crystal polymer and mineral fiber, or a mixture of liquid crystal polymer, glass fiber and mineral fiber.

10. The impeller as claimed in claim 1, **characterized in that** the plurality of blades (2) does not extend beyond a top face of the hub (1).

11. A cooling fan comprising:
a fan frame (5) including a base (51), wherein the base (51) includes a shaft tube (52);
a stator (6) mounted around an outer periphery of the shaft tube (52), wherein the cooling fan is **characterized in** further comprising the impeller as claimed in claim 1, wherein the impeller is rotatably coupled with the shaft tube (52).

## Patentansprüche

1. Laufrad, umfassend:
eine Nabe (1);
eine Vielzahl von Blättern (2), die um einen Außenumfang der Nabe (1) herum vorgesehen sind, wobei jede der Vielzahl von Blättern (2) eine obere Kante (21) und eine untere Kante (22) gegenüber der oberen Kante (21) aufweist, wobei das Laufrad ferner mindestens zwei Verbindungsringe (3) aufweist, die mit der Vielzahl von Blättern (2) verbunden sind, wobei einer oder mehrere der mindestens zwei Verbindungsringe (3) zwischen den oberen Kanten (21) und den unteren Kanten (22) der Vielzahl von Blättern (2) angeordnet, aber nicht mit diesen verbunden sind;
wobei das Laufrad **dadurch gekennzeichnet ist, dass**:
jeder der mindestens zwei Verbindungsringe (3) eine Dicke (T1) aufweist, die größer oder gleich einer maximalen Dicke (T2) jedes der Vielzahl von Blättern (2) ist;
jeder der mindestens zwei Verbindungsringe (3) eine radiale Breite (B) aufweist, die größer oder gleich der maximalen Dicke (T2) jedes der Vielzahl von Blättern (2) ist,
wobei jede der Vielzahl von Blättern (2) eine Länge (L3) zwischen einem ersten Ende (2a) und einem zweiten Ende (2b) davon aufweist, die Nabe (1) eine ringförmige Wand (11) aufweist, die mit dem ersten Ende (2a) jeder der Vielzahl von Blättern (2) verbunden ist, und wobei jeder der mindestens zwei Verbindungsringe (3) mit jeder der Vielzahl von Blättern (2) an einer beliebigen Position vom zweiten Ende (2b) bis zu der Stelle verbunden ist, an der er sich bei einem Drittel der Länge (L3) von der ringförmigen Wand (11) befindet.

2. Laufrad nach Anspruch 1, **dadurch gekennzeichnet, dass** die mindestens zwei Verbindungsringe (3) auf gleicher Ebene liegen.

3. Laufrad nach Anspruch 2, **dadurch gekennzeichnet, dass** die mindestens zwei Verbindungsringe (3) in der Mitte zwischen den Oberkanten (21) und den Unterkanten (22) der Vielzahl von Blättern (2) angeordnet sind.

4. Laufrad nach Anspruch 1, **dadurch gekennzeichnet, dass** einer der mindestens zwei Verbindungsringe (3) mit dem zweiten Ende (2b) jeder der Vielzahl von Blättern (2) verbunden ist.

5. Laufrad nach Anspruch 4, **dadurch gekennzeichnet, dass** die ringförmige Wand (11) einen Verlängerungsabschnitt (111) aufweist, der sich radial nach außen erstreckt und mit den ersten Enden (2a) der Vielzahl von Blättern (2) verbunden ist.

6. Laufrad nach Anspruch 1, **dadurch gekennzeichnet, dass** bei jeder der Vielzahl von Blättern (2) das zweite Ende (2b) höher als das erste Ende (2a) ist, und wobei ein Abstand zwischen der oberen Kante (21) und der unteren Kante (22) des Blattes (2) allmählich von dem ersten Ende (2a) zu dem zweiten Ende (2b) des Blattes (2) hin zunimmt.

7. Laufrad nach Anspruch 1, **dadurch gekennzeichnet, dass** die mindestens zwei Verbindungsringe (3) zwei Verbindungsringe (3) umfassen, wobei einer der zwei Verbindungsringe (3) zwischen den Oberkanten (21) und den Unterkanten (22) der Vielzahl von Blättern (2) angeordnet, aber nicht mit diesen verbunden ist, und wobei ein anderer der zwei Verbindungsringe (3) mit der Vielzahl von Blättern (2) etwas oberhalb oder unterhalb der Oberkanten (21) der Vielzahl von Blättern (2) oder etwas oberhalb oder unterhalb der Unterkanten (22) der Vielzahl von Blättern (2) verbunden ist.

8. Laufrad nach Anspruch 1, **dadurch gekennzeichnet, dass** die mindestens zwei Verbindungsringe (3) drei Verbindungsringe (3) umfassen, wobei einer der drei Verbindungsringe (3) zwischen den Oberkanten (21) und den Unterkanten (22) der Mehrzahl von Blättern (2) angeordnet, aber nicht mit diesen verbunden ist, wobei zwei weitere der drei Verbindungsringe (3) mit den Oberkanten (21) bzw. den Unterkanten (22) der Vielzahl von Blättern (2) verbunden sind, und wobei der eine der drei Verbindungsringe (3) näher an der Nabe (1) liegt als die anderen zwei der drei Verbindungsringe (3).

9. Laufrad nach Anspruch 1, **dadurch gekennzeichnet, dass** die Vielzahl von Blättern (2) und die mindestens zwei Verbindungsringe (3) aus einem Polymer hergestellt sind, und wobei das Polymer eine Mischung aus Flüssigkristallpolymer und Kohlenstofffaser, eine Mischung aus Flüssigkristallpolymer und Mineralfaser oder eine Mischung aus Flüssigkristallpolymer, Glasfaser und Mineralfaser ist.

10. Laufrad nach Anspruch 1, **dadurch gekennzeichnet, dass** die Mehrzahl von Blättern (2) nicht über eine Oberseite der Nabe (1) hinausragt.

11. Kühlgebläse, umfassend:
einen Gebläserahmen (5) mit einer Basis (51), wobei die Basis (51) ein Schaftrohr (52) aufweist;
einen Stator (6), der um einen Außenumfang des Schaftrohrs (52) herum montiert ist, wobei das Kühlgebläse **dadurch gekennzeichnet ist, dass** es ferner das Laufrad nach Anspruch 1 umfasst, wobei das Laufrad drehbar mit dem Schaftrohr (52) gekoppelt ist.

## Revendications

1. Une roue à pales comprenant:
un moyeu (1);
une pluralité de pales (2) disposées autour d'une périphérie extérieure du moyeu (1), dans laquelle chacune de la pluralité de pales (2) a un bord supérieur (21) et un bord inférieur (22) opposé au bord supérieur (21), dans laquelle la roue comprend en outre au moins deux anneaux de connexion (3) reliés à la pluralité de pales (2), dans laquelle un ou plusieurs des au moins deux anneaux de connexion (3) est disposé entre les bords supérieurs (21) et les bords inférieurs (22) de la pluralité de pales (2), mais sans y être relié ;
dans lequel la roue est **caractérisée en ce que**:
chacun des au moins deux anneaux de connexion (3) a une épaisseur (T1) supérieure ou égale à l'épaisseur maximale (T2) de chacune des pales (2) ;
chacun des au moins deux anneaux de connexion (3) a une largeur radiale (B) supérieure ou égale à l'épaisseur maximale (T2) de chacune des pales (2),
dans lequel chacune de la pluralité de pales (2) a une longueur (L3) entre une première extrémité (2a) et une deuxième extrémité (2b) de celle-ci, le moyeu (1) a une paroi annulaire (11) reliée à la première extrémité (2a) de chacune de la pluralité de pales (2), et dans lequel chacun des au moins deux anneaux de connexion (3) est connecté à chacune de la pluralité des pales (2) à n'importe quelle position à partir de la deuxième extrémité (2b) jusqu'à l'endroit où il est à un tiers de la longueur (L3) de la paroi annulaire (11).

2. La roue à pales selon la revendication 1, **caractérisée en ce que** les au moins deux anneaux de connexion (3) sont au même niveau.

3. La roue à pales selon la revendication 2, **caractérisée en ce que** les au moins deux anneaux de connexion (3) sont disposés au milieu entre les bords supérieurs (21) et les bords inférieurs (22) de la pluralité de pales (2).

4. La roue à pales selon la revendication 1, **caractérisée en ce que** l'un des au moins deux anneaux de connexion (3) est relié à la deuxième extrémité (2b) de chacune de la pluralité de pales (2).

5. La roue à pales selon la revendication 4, **caractérisée en ce que** la paroi annulaire (11) comprend une partie d'extension (111) s'étendant radialement vers l'extérieur et reliée aux premières extrémités (2a) de la pluralité de pales (2).

6. La roue à pales selon la revendication 1, **caractérisée en ce que** chacune de la pluralité de pales (2) a la deuxième extrémité (2b) plus haute que la première extrémité (2a), et dans laquelle une distance entre le bord supérieur (21) et le bord inférieur (22) de la pale (2) augmente progressivement de la première extrémité (2a) à la deuxième extrémité (2b) de la pale (2).

7. La roue à pales selon la revendication 1, **caractérisée en ce que** les au moins deux anneaux de connexion (3) comprennent deux anneaux de connexion (3), dans lesquels un des deux anneaux de connexion (3) est disposé entre les bords supérieurs (21) et les bords inférieurs (22) de la pluralité de pales (2), mais n'y est pas connecté, et dans lesquels un autre des deux anneaux de connexion (3) est connecté à la pluralité de pales (2) légèrement au-dessus ou au-dessous des bords supérieurs (21) de la pluralité de pales (2) ou légèrement au-dessus ou au-dessous des bords inférieurs (22) de la pluralité de pales (2).

8. La roue à pales selon la revendication 1, **caractérisée en ce que** les au moins deux anneaux de raccordement (3) comprennent trois anneaux de raccordement (3), dans lesquels l'un des trois anneaux de raccordement (3) est disposé entre les bords supérieurs (21) et les bords inférieurs (22) de la pluralité de pales (2), mais n'est pas relié à ces derniers, dans lequel deux autres des trois anneaux de connexion (3) sont reliés aux bords supérieurs (21) et aux bords inférieurs (22) de la pluralité de pales (2), respectivement, et dans lequel l'un des trois anneaux de connexion (3) est plus adjacent au moyeu (1) que ne le sont les deux autres des trois anneaux de connexion (3).

9. La roue à pales selon la revendication 1, **caractérisée en ce que** la pluralité de pales (2) et les au moins deux anneaux de raccordement (3) sont en polymère, et que le polymère est un mélange de polymère à cristaux liquides et de fibre de carbone, un mélange de polymère à cristaux liquides et de fibre minérale, ou un mélange de polymère à cristaux liquides, de fibre de verre et de fibre minérale.

10. La roue à pales selon la revendication 1, **caractérisée en ce que** la pluralité de pales (2) ne dépasse pas la face supérieure du moyeu (1).

11. Ventilateur de refroidissement comprenant:
un cadre de ventilateur (5) comprenant une base (51), dans lequel la base (51) comprend un tube d'arbre (52) ;
un stator (6) monté autour d'une périphérie extérieure du tube d'arbre (52), dans lequel le ventilateur de refroidissement est **caractérisé en ce qu'**il comprend en outre la roue telle que revendiquée dans la revendication 1, dans laquelle la roue est couplée de manière rotative avec le tube d'arbre (52).
